# EUROPÄISCHE PATENTSCHRIFT

(11) **EP 1 113 526 B1**
(45) Veröffentlichungstag und Bekanntmachung des Hinweises auf die Patenterteilung: **20.07.2005**
(21) Anmeldenummer: 00125119.8
(22) Anmeldetag: 17.11.2000
(51) Int. Cl.: H01R 12/04, H01R 4/24

(54) **Verfahren zum Montieren eines Schneidkontaktes**
Procedure to mount an insulation displacement contact
Procédé pour monter un contact autodénudant

(30) Priorität: 27.12.1999 DE 19963287
(43) Veröffentlichungstag der Anmeldung: 04.07.2001
(73) Patentinhaber: TridonicAtco GmbH & Co. KG, 6851 Dornbirn (AT)
(72) Erfinder: Huber, Christoph, 6853 Dornbirn (AT)
(74) Vertreter: Rupp, Christian, Dipl.-Phys.

(56) Entgegenhaltungen:
- EP-A- 0 620 617
- GB-A- 1 420 230
- GB-A- 2 307 116
- US-A- 5 622 508

## Beschreibung

Die vorliegende Erfindung betrifft ein Verfahren zum Montieren eines Schneidkontaktes auf eine Leiterplatte.

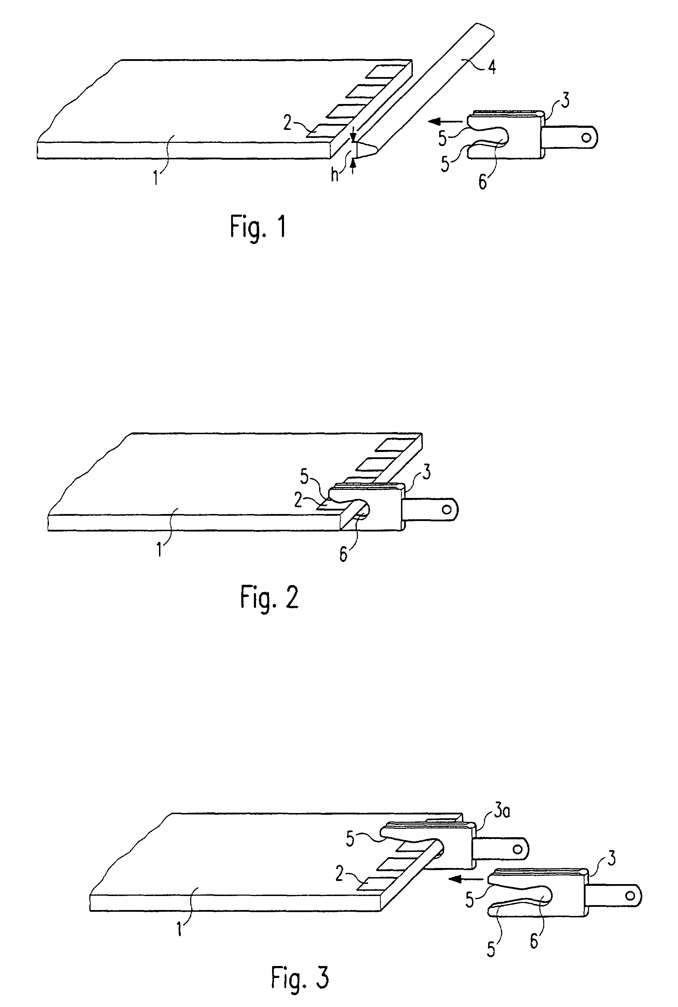

Durch die Verwendung von gedruckten Schaltkreisen oder Mehrlagenschaltungen kann eine deutliche Reduzierung der räumlichen Abmessungen einer elektronischen Schaltung erreicht werden. Zum Kontaktieren einer derartigen Leiterplatte weist diese üblicherweise am Rand sog. Kontakt-Pads auf, die durch mit einem leitfähigen Material bedruckte Flächen gebildet werden. Auf diese Kontakt-Pads werden mit dem Ende einer Anschlußleitung verbundene Schneidkontakte aufgeschoben, wie dies beispielsweise in Fig. 3 dargestellt ist. Als Schneidkontakt werden im folgenden Kontaktierungselemente bezeichnet, die einen Schneid- bzw. einen Schneidklemmkontakt aufweisen.

Fig. 3 zeigt einen üblichen Schneidkontkakt 3, der zum Kontaktieren einer Leiterplatte 1 verwendet werden soll. Die gedruckte Leiterplatte besteht in der Regel aus einer gesinterten Keramik-Folie und weist daher eine relativ hohe Härte auf. Je nach Komplexität der elektronischen Schaltung können diese Leiterplatten 1 unterschiedliche Größen aufweisen. Dabei ist es bei der Herstellung dieser Leiterplatten 1 in großen Stückzahlen normalerweise nicht rentabel, jede Keramikfolie 1 einzeln zu bedrucken und zu sintern. Oftmals wird ein großflächiges Keramiksubstrat mit mehreren nebeneinander angeordneten identischen Leiterbahn-Mustern bedruckt und nach dem Einbrennen der Leiterbahnen bzw. dem Sintern der Keramikschicht auf die endgültigen Abmessungen unterteilt, üblicherweise wird es dazu auseinander gebrochen. Dies hat zur Folge, daß die Leiterplatte 1 relativ scharfe Kanten sowie möglicherweise auch Grate aufweisen kann.

Ein auf ein Kontakt-Pad 2 aufzuschiebender Schneidkontakt 3 muß daher relativ lange und nur leicht geneigte Anlaufschrägen 5 aufweisen, damit er mit einem noch vertretbaren Kraftaufwand auf die Leiterplatte 1 aufgeschoben werden kann. Wie bei dem zweiten Schneidkontakt 3a in Fig. 3 zu sehen ist, ragt dann dessen vordere Kante relativ weit über die Leiterplatte 1. Dieser Bereich ist auf der Oberfläche der Leiterplatte 1 freizuhalten, so daß diese insgesamt entsprechend groß gestaltet werden muß. Ferner ist nicht auszuschließen, daß bei den großen Kräfte, die beim Aufschieben des Schneidkontaktes 3 auftreten, die Leiterplatte 1 beschädigt wird oder bricht, da das Keramik-Material zwar einerseits sehr hart, andererseits aber auch ziemlich spröde ist.

Ferner ist aus der EP 0 620 617 A1 ein Verfahren zur Kontaktierung einer Leiterplatte mit Schneidkontakten bekannt, bei welchem die zu kontaktierende Leiterplatte vor dem Aufschieben der Kontakte mit einem Kunststoffblatt umhüllt wird. Die Aufgabe dieses Kunststoffblatts ist es, die Leiterplatte und die auf dieser angebrachten Elemente, also Leiterbahnen und dergleichen während des Aufschiebens der Schneidkontakte zu schützen. Nachdem die Kontakte aufgeschoben wurden, wird das Kunststoffblatt in Kontaktierungsrichtung abgezogen, um letztendlich die Kontaktierung der Leiterplatte zuzulassen. Dieses Abziehen des Kunststoffblatts ist aufgrund der großen Kontaktfläche zwischen Leiterplatte und Kunststoffblatt mit einem verhältnismäßig hohen Kraftaufwand verbunden.

Es ist deshalb Aufgabe der vorliegenden Erfindung, ein verbessertes Verfahren zum Montieren eines Schneidkontaktes auf einer Leiterplatte anzugeben, welches ein einfaches und effektiveres Kontaktieren der Leiterplatte ermöglicht.

Die Aufgabe wird durch ein Verfahren, das die Merkmale des Anspruches 1 aufweist, gelöst. Dieses zeichnet sich dadurch aus, daß vor dem Aufschieben des Schneidkontaktes ein längliches und im Querschnitt keilförmiges Montagewerkzeug an eine Seite der Leiterplatte angeordnet wird. Zum Montieren wird dann der Schneidkontakt über dieses keilförmige Montagewerkzeug auf die Leiterplatte aufgeschoben, wobei das Montagewerkzeug den Schneidkontakt aufbiegt. Anschließend kann dann das Montagewerkzeug seitlich entfernt und für das Kontaktieren einer neuen Leiterplatte wieder verwendet werden. Aufgrund des durch das Montagewerkzeug bedingten kontinuierlichen Aufbiegens bzw. Aufspreizens des Schneidkontaktes kann dieser mit einem wesentlich geringerem Kraftaufwand auf die Leiterplatte aufgeschoben werden. Ferner ist es möglich, die Anlaufschrägen des Schneidkontaktes deutlich kürzer und steiler zu gestalten, so daß diese nach dem Kontaktieren auch weniger weit über die Leiterplatte ragen.

Die Erfindung soll im folgenden anhand der beiliegenden Zeichnung näher erläutert werden. Es zeigen:
- Fig. 1: die Verwendung des keilförmigen Montagewerkzeuges im Rahmen des erfindungsgemäßen Montage-Verfahrens;
- Fig. 2: einen entsprechend dem erfindungsgemäßen Montage-Verfahren auf eine Leiterplatte aufgeschobenen Schneidkontakt, und
- Fig. 3: herkömmliche auf eine Leiterplatte aufgeschobene Schneidkontakte.

Der in Fig. 1 dargestellte Schneidkontakt 3 unterscheidet sich von den herkömmlichen in Fig. 3 dargestellten Schneidkontakten 3 bzw. 3a in erster Linie dadurch, daß die Anlaufschrägen 5 deutlich kürzer und steiler ausgestaltet sind, als dies bisher der Fall war. Wie auch bisher münden die Anlaufschrägen 5 des Schneidkontaktes 3 in eine kreisförmige Öffnung 6, der bei dem erfindungsgemäßen Montage-Verfahren eine besondere Bedeutung zukommt. Das Montagewerkzeug 4 ist länglich und im Querschnitt keilförmig ausgebildet. Die Höhe h des Montagewerkzeuges 4 entspricht in etwa der Höhe der Leiterplatte 1, so daß ein kontinuierlicher Übergang zwischen Montagewerkzeug 4 und Leiterplatte 1 erreicht wird.

Bei der Leiterplatte 1 kann es sich um eine einfache bedruckte Leiterplatte handeln, auf die (nicht dargestellte) Leiterbahnen sowie die Kontakt-Pads 2 mittels Siebdruck aufgebracht wurden. Allerdings kann es sich auch um eine entsprechend dem LTCC-(Low Temperatur Cofired Ceramic)Verfahren hergestellte Mehrlagenschaltung handeln, bei dem mehrere dünne und mit Leiterbahnen bedruckte Keramik-Folien übereinander angeordnet und gemeinsam unter Druck gesintert werden.

Erfindungsgemäß wird vor dem Aufschieben des Schneidkontaktes 3 auf die Leiterplatte 1 das Montagewerkzeug 4 an die Stirnseite der Leiterplatte 1 anliegend angeordnet. Anschließend wird der Schneidkontakt 3 über dieses keilförmige Montagewerkzeug 4 auf die Leiterplatte 1 aufgeschoben, wobei das Montagewerkzeug 4 die beiden gegenüberliegenden Anlaufschrägen 5 kontinuierlich auseinanderbiegt. Die dafür benötigte Kraft ist deutlich niedriger als dies bei einer Leiterplatte 1 mit eckigen Kanten der Fall ist. Nach dem Aufschieben des Schneidkontaktes auf die Leiterplatte 1 befindet sich das Montagewerkzeug 4 innerhalb der kreisförmigen Öffnung 6 des Schneidkontaktes 3. Dabei werden die Abmessungen der Öffnung 6 bzw. des Montagewerkzeuges 4 vorzugsweise so gewählt, daß das Montagewerkzeug 4 innerhalb der Öffnung 6 genügend Spiel besitzt, um durch seitliches Herausziehen einfach entfernt werden zu können. Das Montagewerkzeug 4 kann dann für das Kontaktieren einer weiteren Leiterplatte wieder verwendet werden. Wie auch die Leiterplatte 1 sollte das Montagewerkzeug 4 aus einem sehr harten Material bestehen, wobei sich ebenfalls Keramik anbietet.

Fig. 2 zeigt einen entsprechend dem erfindungsgemäßen Montage-Verfahren auf eine Leiterplatte 1 aufgeschobenen Schneidkontakt 3. Im Vergleich zu den herkömmlichen Schneidkontakten in Fig. 3 ragt dieser deutlich weniger über die Leiterplatte 1, so daß diese entsprechend kleiner ausgestaltet bzw. effektiver auf der Oberfläche bedruckt werden kann. Da bei dem erfindungsgemäßen Kontaktieren auch geringere Kräfte auftreten, als dies bisher der Fall war, ist die Gefahr einer Beschädigung der Leiterplatte 1 deutlich niedriger.

Der gleiche Effekt könnte natürlich auch durch ein Abrunden der Kanten der Leiterplatte 1 erzielt werden. Aus wirtschaftlichen Gründen ist dies allerdings nicht sinnvoll. Ferner hätte ein nachträgliches Abschleifen oder zur Folge, daß die Randbereiche der Leiterplatte 1 eine geringe Höhe aufweisen und dementsprechend wieder anfälliger für Beschädigungen sind. Die beiden zusätzlichen Arbeitsschritte des Anordnens und wieder Entfernens des Montagewerkzeuges 4 werden durch die Vorteile des erfindungsgemäßen Verfahrens deutlich wettgemacht, insbesondere auch aufgrund der Tatsache, daß das Verfahren auch für eine maschinelle Kontaktierung geeignet ist, bei der gleichzeitig mehrere Kontakte auf die Leiterplatte aufgeschoben werden können.

## Patentansprüche

1. Verfahren zum Montieren eines Schneidkontaktes bzw. eines Schneidklemmkontaktes (3) auf eine Leiterplatte (1) mit folgenden Schritten:
a) Anordnen eines länglichen und im Querschnitt keilförmigen Montagewerkzeuges (4) an eine Seite der Leiterplatte (1);
b) Aufschieben des Schneidkontaktes (3) über das keilförmige Montagewerkzeug (4) auf die Leiterplatte (1), wobei das Montagewerkzeug (4) den Schneidkontakt (1) aufspreizt; und
c) seitliches Entfernen Montagewerkzeuges (4).

2. Verfahren nach Anspruch 1,
**dadurch gekennzeichnet,**
**daß** die Höhe des keilförmigen Montagewerkzeuges (4) der Dicke der Leiterplatte (1) entspricht.

3. Verfahren nach Anspruch 1 oder 2,
**dadurch gekennzeichnet,**
**daß** in Schritt b) des Verfahrens mindestens zwei Schneidkontakte (3) gleichzeitig über das Montagewerkzeug (4) auf die Leiterplatte (1) aufgeschoben werden.

4. Verwendung eines im Querschnitt keilförmigen Montagewerkzeuges (4) beim Montieren mindestens eines Schneidkontaktes (3) auf eine Leiterplatte (1), wobei das Montagewerkzeug (4) vor dem Aufschieben des mindestens einen Schneidkontaktes (3) an eine Stirnseite der Leiterplatte (1) anliegend anzuordnen ist und den Schneidkontakt (3) während das Aufschiebens aufspreizt.

## Claims

1. Method of mounting an insulation displacement contact or an insulation piercing contact (3) on a circuit board (1), having the following steps;
a) arranging a mounting tool (4), elongate and wedge-shaped in cross-section, at a side of a circuit board (1);
b) pushing the insulation displacement contact (3) over the wedge-shaped mounting tool (4) on to the circuit board (1), whereby the mounting tool (4) spreads the insulation displacement contact (1) apart; and
c) sideways removal of the mounting tool (4).

2. Method according to claim 1,
**characterized in that**,
the height of the wedge-shaped mounting tool (4) corresponds to the thickness of the circuit board.

3. Method according to claim 1 or 2,
**characterized in that**,
in step b) of the method at least two insulation displacement contacts (3) are pushed over the mounting tool (4) on to the circuit board (1) at the same time.

4. Use of a mounting tool (4), wedge-shaped in cross-section, upon mounting of at least one insulation displacement contact (3) on to a circuit board (1), wherein before the pushing on of the at least one insulation displacement contact (3), the mounting tool (4) is to be arranged bearing on an end side of the circuit board (1) and spreads apart the insulation displacement contact (3) during the pushing on.

## Revendications

1. Procédé de montage d'un contact à sectionnement ou d'un contact à serrage et sectionnement (3) sur une plaque à circuit imprimé (1), comprenant les étapes qui consistent à :
a) placer un outil de montage (4) allongé et de section transversale en forme de coin sur une face de la plaque à circuit imprimé (1) ;
b) par l'intermédiaire de l'outil de montage (4) en forme de coin, enfoncer le contact à sectionnement (3) sur la plaque à circuit imprimé (1), l'outil de montage (4) écartant le contact à sectionnement (1) ; et
c) retirer l'outil de montage (4) par le côté.

2. Procédé selon la revendication 1,
**caractérisé en ce que**
la hauteur de l'outil de montage (4) en forme de coin correspond à l'épaisseur de la plaque à circuit imprimé (1).

3. Procédé selon la revendication 1 ou 2,
**caractérisé en ce que**
lors de l'étape b) du procédé, au moins deux contacts à sectionnement (3) sont simultanément enfoncés sur la plaque à circuit imprimé (1), par l'intermédiaire de l'outil de montage (4).

4. Utilisation d'un outil de montage (4) de section transversale en forme de coin lors du montage d'au moins un contact à sectionnement (3) sur une plaque à circuit imprimé (1), l'outil de montage (4) devant être approché très près d'une face frontale de la plaque à circuit imprimé (1), avant que ne soit enfoncé au moins un contact à sectionnement (3), et écartant le contact à sectionnement (3) lorsqu'il est enfoncé.
